(19)

Europäisches
Patentamt
European
Patent Office
Office européen
des brevets

(11) **EP 3 306 781 A1**

(12) **EUROPEAN PATENT APPLICATION**
published in accordance with Art. 153(4) EPC

(43) Date of publication:
**11.04.2018 Bulletin 2018/15**

(21) Application number: **16803604.4**

(22) Date of filing: **26.04.2016**

(51) Int Cl.:
**H02J 50/00** (2016.01)    **H02J 7/02** (2016.01)

(86) International application number:
**PCT/KR2016/004370**

(87) International publication number:
**WO 2016/195249 (08.12.2016 Gazette 2016/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **04.06.2015 KR 20150079090**

(71) Applicant: **LG Innotek Co., Ltd.
Seoul, 04637 (KR)**

(72) Inventor: **BAE, Su Ho
Seoul 04637 (KR)**

(74) Representative: **DREISS Patentanwälte PartG
mbB
Friedrichstrasse 6
70174 Stuttgart (DE)**

(54) **WIRELESS POWER TRANSMISSION SYSTEM AND METHOD FOR DRIVING SAME**

(57)     Disclosed is a transmission unit having a wireless power transfer function, which may comprise a coil. The transmission unit may further comprise an impedance matching unit including a capacitor which resonates with the coil. Further, the transmission unit may further comprise a detection unit for detecting whether the input impedance of the coil and impedance matching unit includes an imaginary part, and thus perform an FOD through the existence of the imaginary part.

【Figure 5】

EP 3 306 781 A1

**Description**

[Technical Field]

Embodiments relate to a wireless power transfer system and a method of driving the same.

[Background Art]

In general, various types of electronic apparatuses include respective batteries and are driven using power stored in the batteries. In an electronic apparatus, a battery may be replaced or recharged. To this end, the electronic device includes a contact terminal for contact with an external charging device. That is, the electronic apparatus is electrically connected to a charging device through a contact terminal. However, the contract terminal of the electronic apparatus is externally exposed and thus may be contaminated by foreign materials or short-circuited by moisture. In this case, contact failure occurs between the contact terminal and the charging device and thus the battery of the electronic apparatus is not charged.
In order to solve the above-described problem, wireless power transfer (WPT) for wirelessly charging the electronic apparatus is proposed.
A WPT system transfers power over the air without a wire, thereby maximizing convenience of supply of power to a mobile apparatuses and digital appliances.
A WPT system has advantages such as energy conservation through real-time power use control, overcoming of power supply space restriction, and reduction in number of used batteries through battery recharging.
Representative examples of a method of implementing a WPT system include a magnetic induction method and a magnetic resonance method. The magnetic induction method uses a non-contact energy transmission technology for providing two coils close to each other and generating electromotive force in the other coil by magnetic flux generated when current flows in one coil, and may use a frequency of several hundred kHz. The magnetic resonance method uses a magnetic resonance technology of using only an electric field or a magnetic field without an electromagnetic wave or current, has a power transfer distance of more than several of meters, and may use a band of several MHz.
A WPT system includes a transfer unit for wirelessly transferring power and a reception unit for receiving power and charging a load such as a battery. At this time, a transfer unit capable of selecting the charging method of the reception unit, that is, any one of the magnetic induction method and the magnetic resonance method, and wirelessly transferring power in correspondence with the charging method of the reception unit has been developed.
Meanwhile, in a method of receiving energy through a contact terminal, if terminal connection is normally established between a charging device and a battery, charging is unlikely to be interrupted by a foreign object. However, in the WPT system, a foreign object may be inserted between the transfer unit and the reception unit upon charging due to non-contact charging properties. If a foreign object such as metal are inserted between the transfer unit and the reception unit, power may not be smoothly transferred due to a foreign object and failure and explosion of a product may occur due to overload and heating of a foreign object. Accordingly, there is a need for a device and method for accurately detecting a foreign object in a WPT system.

[Disclosure]

[Technical Problem]

Embodiments provide a wireless power transfer system for accurately determining presence/absence of a foreign object in a charging region of a transfer unit, and a method of driving the same.

[Technical Solution]

In accordance with one embodiment, a transfer unit having a wireless power transfer function includes a coil, an impedance matching unit including a capacitor resonating with the coil; and a detector configured to detect presence/absence of an imaginary-number part of input impedance of the impedance matching unit and the coil.
Presence/absence of the imaginary-number part of the input impedance may be detected to detect whether an object is placed in a charging area of the transfer unit.
When the imaginary-number part of the input impedance is detected, the object may be determined as a metal foreign object.
The transfer unit may further include a direct current (DC)-to-alternating current (AC) converter configured to convert an input DC signal into an AC signal and to output the AC signal to the coil, and the detector may sense the AC signal and detects presence/absence of the imaginary-number part of the input impedance.

The detector may detect change in time width of the AC signal and detects presence/absence of the imaginary-number part of the input impedance.

When a metal foreign object is placed in a charging area of the transfer unit, the time width may be reduced.

In accordance with another embodiment, a transfer unit having a wireless power transfer function includes a power converter configured to convert power of an input signal and to output an alternating current (AC) signal, a resonant circuit unit configured to convert the AC signal into a magnetic field, and a detector configured to detect the AC signal, wherein change in time width of the AC signal is detected to determine presence/absence of an object in a charging area of the transfer unit.

When the object is a metal foreign object, a time width of the AC signal may be reduced.

The power converter may include an amplifier configured to output only a positive half-period of the AC signal.

The transfer unit may further include a controller configured to generate a pulse signal having a width corresponding to a time width of a positive half-period of the AC signal, to generate a DC voltage, a level of which is changed according to a pulse width of the pulse signal, and to compare the DC voltage with a predetermined value to determine presence/absence of the object.

The controller may include a comparator configured to compare the AC signal with a reference voltage and to generate a pulse signal having a width corresponding to the time width of the positive half-period of the AC signal; and an RC filter configured to generate the DC voltage, the level of which is changed according to the pulse width of the pulse signal.

In accordance with another embodiment, a transfer unit configured to wirelessly transfer power to at least one of a plurality of objects in a charging area includes a power converter configured to convert power of an input signal and to output an alternating current (AC) signal, a transfer-side resonant circuit unit configured to convert the AC signal into a magnetic field, and a detector configured to detect the AC signal, wherein change in time width of the AC signal is detected to determine whether at least one of the plurality of objects is a metal foreign object.

When at least one of the plurality of objects is a metal foreign object, a time width of the AC signal may be reduced.

The power converter may include an amplifier configured to output only a positive half-period of the AC signal.

The transfer unit may further include a controller configured to generate a pulse signal having a width corresponding to a time width of a positive half-period of the AC signal, to generate a DC voltage, a level of which is changed according to a pulse width of the pulse signal, and to compare the DC voltage with a predetermined value to determine whether at least one of the plurality of objects is a metal foreign object.

The controller may include a comparator configured to compare the AC signal with a reference voltage and to generate a pulse signal having a width corresponding to the time width of the positive half-period of the AC signal, and an RC filter configured to generate the DC voltage, the level of which is changed according to the pulse width of the pulse signal.

In accordance with another embodiment, a transfer unit configured to wirelessly transfer power to at least one of a plurality of objects in a charging area includes a power converter configured to convert power of an input signal and to output an alternating current (AC) signal, a transfer-side resonant circuit unit configured to convert the AC signal into a magnetic field, and a detector configured to detect the AC signal, wherein presence/absence of an imaginary-number part of input impedance of the resonant circuit unit is detected to determine whether at least one of the plurality of objects is a metal foreign object.

The detector may sense the AC signal and detect presence/absence of the imaginary-number part of the input impedance.

The detector may detect change in time width of the AC signal and detect the imaginary-number part of the input impedance.

When at least one of the plurality of objects is a metal foreign object, the time width may be reduced.

In accordance with another embodiment, a method of operating a transfer unit includes a standby phase of determining presence/absence of an object in a charging area, a digital ping phase of requesting a response to a digital ping from the object, an identification phase of requesting identification information from the object, and a power transfer phase of transmitting wireless power to the object, wherein presence/absence of an imaginary-number part of input impedance of the transfer unit is detected to detect a metal foreign object placed in the charging area.

When the imaginary-number part of the input impedance is detected, the transfer unit may perform a notification function.

When the imaginary-number part of the input impedance is detected in the standby phase, the transfer unit may maintain the standby phase.

When the imaginary-number part of the input impedance is detected in any one of the digital ping phase, the identification phase and the power transfer phase, the phase of the transfer unit may transition to the standby phase.

When the imaginary-number part of the input impedance is detected in the power transfer phase, the transfer unit may transmit metal foreign object detection information to a reception unit configured to receive power from the transfer unit.

When a temperature of the charging area of the transfer unit is equal to or greater than a predetermined temperature, the transfer unit may detect presence/absence of an imaginary-number part of input impedance.

When information indicating that a temperature of the charging area is equal to or greater than a predetermined temperature is received from the reception unit configured to receive power from the transfer unit, the transfer unit may detect presence/absence of an imaginary-number part of input impedance.

[Advantageous Effect]

In a wireless power transfer (WPT) system according to an embodiment, a transfer unit can perform foreign object detection (FOD) without feedback of information between the transfer unit and the reception unit.

In a wireless power transfer (WPT) system according to an embodiment, it is possible to accurately detect a foreign object (FO) in a charging region of a transfer unit, regardless of misalignment between the transfer unit and the reception unit.

[Description of Drawings]

FIG. 1 is an equivalent circuit diagram of a magnetic induction method.

FIG. 2 is an equivalent circuit diagram of a magnetic resonance method.

FIGS. 3a and 3b are block diagrams showing a transfer unit as a subsystem configuring a wireless power transfer (WPT) system.

FIG. 4 is a block diagram showing a reception unit as a subsystem configuring a WPT system.

FIG. 5 is a flowchart illustrating operation of a WPT system and, more particularly, operation of a transfer unit.

FIG. 6 is a circuit diagram showing an impedance matching unit and a transfer-side coil of a transfer unit as a serial RLC equivalent circuit.

FIG. 7 is a circuit diagram showing an impedance matching unit and a transfer-side coil of a transfer unit as a serial RLC equivalent circuit and a foreign object (FO) equivalent circuit.

FIG. 8 is a circuit diagram showing an impedance matching unit and a transfer-side coil of a transfer unit and an impedance matching unit and a reception-side coil of a reception unit as a serial RLC equivalent circuit.

FIG. 9 is an equivalent circuit diagram of a transfer-side DC-to-AC converter, a transfer-side impedance matching unit and a transfer-side coil according to an embodiment.

FIG. 10 is a diagram showing the output waveform of a transfer-side DC-to-AC converter of FIG. 9.

FIG. 11 is a circuit diagram showing a FO determination unit.

FIG. 12 is a graph showing the waveforms of input and output signals of the FO determination unit.

[Best Mode]

Hereinafter, a wireless power transfer system including a transfer unit including a function for wirelessly transferring power and a reception unit for wirelessly receiving power according to embodiments will be described in detail with reference to the accompanying drawings. The embodiments described below are merely provided by way of example in order to allow the spirit of the present invention to be sufficiently conveyed to those skilled in the art. Thus, the embodiments are not limited to the embodiments described below and may be embodied in other forms. In addition, in the drawings, for example, sizes and thicknesses of constituent elements of a device may be exaggerated for convenience. The same reference numbers will be used throughout the specification to refer to the same or like constituent elements.

In the embodiments, various frequency bands from a low frequency (50 kHz) to a high frequency (15 MHz) may be selectively used for wireless power transfer and a communication system capable of exchanging data and control signals for system control may be included.

Embodiments are applicable to the mobile terminal industry, the smart watch industry and the computer and laptop industries, the home appliance industry, the electric vehicle industry, the medical device industry, robotics, etc. using electronic devices which use or require respective batteries.

In Embodiments, a system capable of transferring power to one or more apparatuses using one or a plurality of transfer coils may be considered.

According to embodiments, a battery shortage problem of a mobile device such as a smartphone or a laptop may be solved. For example, when a smartphone or a laptop is used in a state of being placed on a wireless charging pad located on a table, the battery may be automatically charged and thus the smartphone or the laptop can be used for a long time. In addition, when a wireless charging pad is installed in public places such as cafes, airports, taxis, offices and restaurants, various mobile apparatuses can be charged regardless of the type of the charging terminal changed according to mobile apparatus manufacturer. In addition, when wireless power transfer technology is applied to household appliances such as cleaners, electric fans, etc., effort to find a power cable is not necessary and complicated wires are not required in the home, thereby reducing the number of wires in a building and making better use of space. In addition, charging an electric vehicle using a household power supply takes considerable time. In contrast, when high power is transferred through wireless power transfer technology, charging time can be reduced. In addition, when wireless charging equipment is mounted in a parking area, a power cable does not need to be provided near the electric vehicle.

The terms and abbreviations used in the embodiments will now be described.

Wireless Power Transfer System: System for wirelessly transferring power within a magnetic field.

Transfer unit (Wireless Power Transfer System-Charger): Device for wirelessly transferring power to a power receiver in a magnetic field and managing the system.

Reception unit (Wireless Power Receiver System-Device): Device for wirelessly receiving power from a power transferer in a magnetic field.

Charging Area: Area in which wireless power transfer is performed in a magnetic field and which may be changed according to the size, desired power or operating frequency of an application product.

S parameter (Scattering parameter): Ratio of an input voltage to an output voltage in a frequency distribution, that is, a ratio of an input port to an output port (Transmission; $S_{21}$) or a reflection value of an input/output port, that is, an output value returned by reflection of an input value (Reflection; $S_{11}$, $S_{22}$).

Q (Quality factor): In resonance, a value Q means frequency selection quality. As the Q value increases, a resonance property becomes better, and the Q value is represented by a ratio of energy stored in a resonator to lost energy.

Examples of the principle of wirelessly transferring power include a magnetic induction method and a magnetic resonance method.

The magnetic induction method uses a non-contact energy transmission technology for providing a source inductor $L_s$ and a load inductor $L_l$ close to each other and generating electromotive force in the load inductor $L_l$ by magnetic flux generated when current flows in the source inductor $L_s$. The magnetic resonance method uses technology for wirelessly transferring energy using a resonance method of generating magnetic resonance by a natural frequency between two resonators and forming an electric field and a magnetic field in the same wavelength range while vibrating with the same frequency.

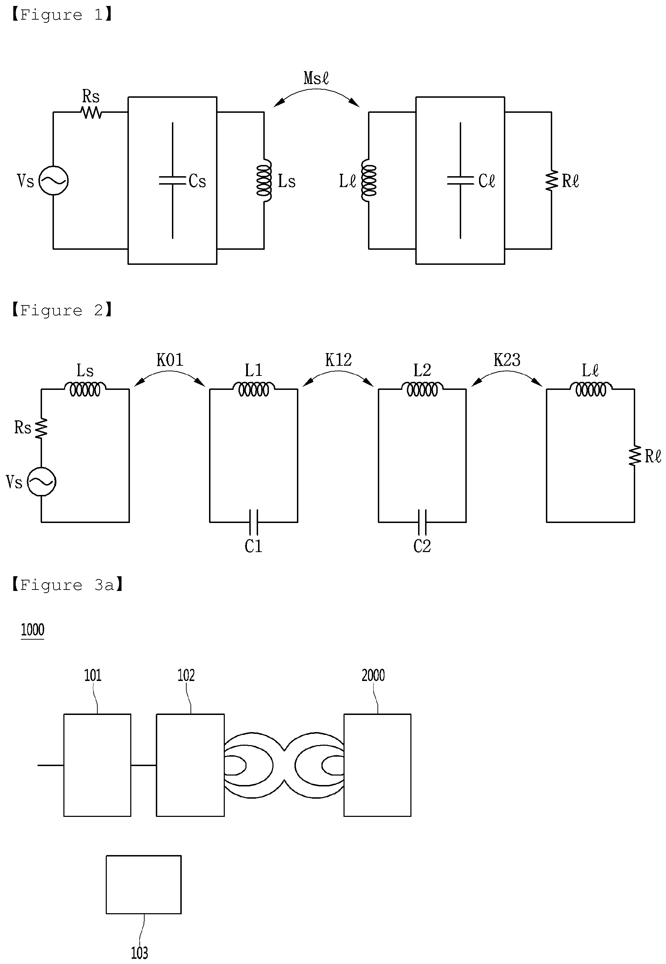

FIG. 1 is a diagram showing a magnetic induction type equivalent circuit.

Referring to FIG. 1, in a magnetic induction type equivalent circuit, a transfer unit may be implemented by a source voltage $V_s$ according to a device for supplying power, a source resistor $R_s$, and a source capacitor $C_s$ for impedance matching, and a source coil $L_s$ for magnetic coupling with a reception unit, and the reception unit may be implemented by a load resistor $R_l$ which is an equivalent resistor of the reception unit, a load capacitor $C_l$ for impedance matching and a load coil $L_l$ for magnetic coupling with the transfer unit. Magnetic coupling between the source coil $L_s$ and the load coil $L_l$ may be represented by mutual inductance $M_{sl}$.

In FIG. 1, when a ratio $S_{21}$ of an input voltage to an output voltage is obtained from a magnetic induction equivalent circuit including only coils without the source capacitor $C^s$ and the load capacitor $C_l$ for impedance matching, a maximum power transfer condition satisfies Equation 1 below.

$$\mathrm{Equation\ 1}$$

$$L_s/R_s = L_l/R_l$$

According to Equation 1 above, when a ratio of inductance of the transfer coil $L_s$ to the source resistor $R_s$ is equal to a ratio of the inductance of the load coil $L_1$ to the load resistor $R_l$, maximum power transfer is possible. In a system including only inductance, since a capacitor capable of compensating for reactance is not present, the reflection value $S_{11}$ of the input/output port cannot become 0 at a maximum power transfer point and power transfer efficiency can be significantly changed according to mutual inductance $M_{sl}$. Therefore, as a compensation capacitor for impedance matching, the source capacitor $C_s$ may be added to the transfer unit and the load capacitor $C_l$ may be added to the reception unit. The compensation capacitors $C_s$ and $C_l$ may be connected to the reception coil $L_s$ and the load coil $L_l$ in series or in parallel, respectively. In addition, for impedance matching, passive elements such as additional capacitors and inductors may be further included in the transfer unit and the reception unit, in addition to the compensation capacitors.

FIG. 2 is a diagram showing a magnetic resonance type equivalent circuit.

Referring to FIG. 2, in the magnetic resonance type equivalent circuit, a transfer unit is implemented by a source coil configuring a closed circuit by series connection of a source voltage $V_s$, a source resistor $R_s$ and a source inductor $L_s$ and a transfer-side resonant coil configuring a closed circuit by series connection of a transfer-side resonant inductor $L_1$ and a transfer-side resonant capacitor $C_1$, and a reception unit is implemented by a load coil configuring a closed circuit by series connection of a load resistor $R_l$ and a load inductor $L_l$ and a reception-side resonant coil configuring a closed circuit by series connection of a reception-side resonant inductor $L_2$ and a reception-side resonant capacitor $C_2$. The source inductor $L_s$ and the transfer-side inductor $L_1$ are magnetically coupled with a coupling coefficient of $K_{01}$, the load inductor $L_l$ and the load-side resonant inductor $L_2$ are magnetically coupled with a coupling coefficient of $K_{23}$, and the transfer-side resonant inductor $L_1$ and the reception-side resonant inductor $L_2$ are coupled with a coupling coefficient of $L_{12}$. In an equivalent circuit of another embodiment, the source coil and/or the load coil may be omitted and only the transfer-side resonant coil and the reception-side resonant coil may be included.

In the magnetic resonance method, when the resonant frequencies of the two resonators are equal, most of the energy of the resonator of the transfer unit may be transferred to the resonator of the reception unit, thereby improving power transfer efficiency. Efficiency of the magnetic resonance method becomes better upon satisfying Equation 2 below.

```
        Equation 2
        k/Γ >> 1 (k being a coupling coefficient and Γ being
a damping ratio)
```

In order to increase efficiency in the magnetic resonance method, impedance matching elements may be added and the impedance matching elements may be passive elements such as an inductor and a capacitor.

A WPT system for transferring power using a magnetic induction method or a magnetic resonance method based on the wireless power transfer principle will now be described.

<Transfer unit>

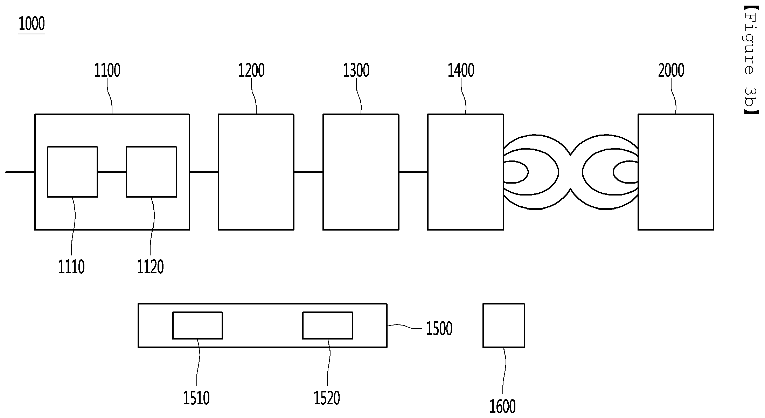

FIGS. 3a and 3b are block diagrams showing a transfer unit as one of subsystems configuring a wireless power transfer system.

Referring to FIG. 3a, the wireless power transfer system according to the embodiment may include a transfer unit 1000 and a reception unit 2000 for wirelessly receiving power from the transfer unit 1000. The transfer unit 1000 may include a power converter 101 for performing power conversion with respect to an input AC signal and outputting an AC signal, a resonant circuit unit 102 for generating a magnetic field based on the AC signal output from the power converter 101 and supplying power to the reception unit 2000 in a charging area, and a controller 103 for controlling power conversion of the power converter 101, adjusting the amplitude and frequency of the output signal of the power converter 101, performing impedance matching of the resonant circuit unit 102, sensing impedance, voltage and current information from the power converter 101 and the resonant circuit 102 and performing wireless communication with the reception unit 2000. The power converter 101 may include at least one of a power converter for converting an AC signal into a DC signal, a power converter for changing the level of a DC signal and outputting a DC signal, and a power converter for converting a DC signal into an AC signal. The resonant circuit unit 102 may include a coil and an impedance matching unit resonating with the coil. In addition, the controller 103 may include a sensing unit for sensing impedance, voltage and current information and a wireless communication unit.

Specifically, referring to FIG. 3b, the transfer unit 1000 may include a transfer-side AC-to-DC converter 1100, a transfer-side DC-to-AC converter 1200, a transfer-side impedance matching unit 1300, a transfer coil unit 1400 and a transfer-side communication and control unit 1500.

The transfer-side AC-to-DC converter 1100 may convert an externally input AC signal into a DC signal under control of the transfer-side communication and control unit 1500 and may include a rectifier 1110 and a transfer-side AC/AC converter 1120 as subsystems. The rectifier 1110 is a system for converting the received AC signal into a DC signal and may be implemented by a diode rectifier having relatively high efficiency upon high-frequency operation, a synchronous rectifier capable of being built in one chip, and a hybrid rectifier capable of reducing cost and space and a high degree of freedom in terms of a dead time. The embodiments are not limited thereto and any system for converting an AC signal into a DC signal is applicable. In addition, the transfer-side DC-to-DC converter 1120 adjusts the level of the DC signal received from the rectifier 1110 under control of the transfer-side communication and control unit 1500, and examples thereof include a buck converter for decreasing the level of an input signal, a boost converter for increasing the level of an input signal, and a buck boost converter for decreasing or increasing the level of an input signal, or a Cuk converter. In addition, the transfer-side DC-to-DC converter 1120 may include a switch element for performing a power conversion control function, an inductor and capacitor for performing a power conversion intermediation function or an output voltage smoothing function, a transformer for performing a voltage gain adjustment or electrical separation (insulation) function, etc., and perform a function for removing a ripple component or pulsatory component (AC component included in the DC signal) included in the input DC signal. A difference between the command value of the output signal of the transfer-side DC-to-DC converter 1120 and an actual output value may be adjusted through a feedback method, which may be performed by the transfer-side communication and control unit 1500.

The transfer-side DC-to-AC converter 1200 is a system for converting the DC signal output from the transfer-side AC-to-DC converter 1100 into an AC signal under control of the transfer-side communication and control unit 1500 and adjusting the frequency of the converted AC signal, and examples thereof include a half-bridge inverter or a full-bridge inverter. The wireless power transfer system may include various amplifiers for converting DC into AC, e.g., A-class, B-class, AB-class, C-class, E-class and F-class amplifiers. In addition, the transfer-side DC-to-AC converter 1200 may include an oscillator for generating the frequency of the output signal and a power amplifier for amplifying the output signal.

The transfer-side impedance matching unit 1300 minimizes a reflected wave to enable the signal to smoothly flow at a point having different impedances. Since the two coils of the transfer unit 1000 and the reception unit 2000 are separated from each other, the magnetic field is significantly leaked. Therefore, an impedance difference between the two connection ends of the transfer unit 1000 and the reception unit 2000 may be corrected, thereby improving power transfer efficiency. The transfer-side impedance matching unit 1300 may include an inductor, a capacitor and a resistor and change inductance of the inductor, capacitance of the capacitor and resistance of the resistor under control of the communication and control unit 1500, thereby adjusting the impedance value for impedance matching. When the wireless power transfer system transfers power using the magnetic induction method, the transfer-side impedance matching unit 1300 may have a series resonant structure or a parallel resonant structure and increase an induction coupling coefficient between the transfer unit 1000 and the reception unit 2000, thereby minimizing energy loss. When the wireless power transfer system transfers power using the magnetic resonance method, the transfer-side impedance matching unit 1300 may correct impedance matching in real time by change in matching impedance on an energy transmission line due to change in distance between the transfer unit 1000 and the reception unit 2000 or change in properties of the coil according to mutual influence of a plurality of devices and metal foreign objects (FOs). Examples of the correction method may include a multi-matching method using a capacitor, a matching method using multiple antennas and a method using multiple loops.

The transfer-side coil 1400 may be implemented by one or a plurality of coils. If the transfer-side coil 1400 includes a plurality of coils, the coils may be spaced apart from each other or overlap each other. If the coils overlap each other, the overlapping area may be determined in consideration of a flux density variation. In addition, the transfer-side coil 1400 may be manufactured in consideration of internal resistance and radiation resistance. At this time, if a resistance component is small, a quality factor may be increased and transmission efficiency may be increased.

The communication and control unit 1500 may include a transfer-side controller 1510 and a transfer-side communication unit 1520. The transfer-side controller 1510 may be responsible for adjusting the output voltage of the transfer-side AC-to-DC converter 1100 in consideration of desired power of the reception unit 2000, a current charging amount, and a wireless power method. In consideration of maximum power transfer efficiency, frequencies and switching waveforms for driving the transfer-side DC-to-AC converter 1200 may be generated to control power to be transferred. In addition, overall operation of the reception unit 2000 may be controlled using an algorithm, program or application read from a memory (not shown) of the reception unit 2000 and required for control. Meanwhile, the transfer-side controller 1510 may be referred to as a microprocessor, a microcontroller unit, or a Micom. The transfer-side communication unit 1520 may perform communication with the reception-side communication unit 2620 and examples of the communication method may include a short-range communication method such as Bluetooth, NFC or ZigBee. The transfer-side communication unit 1520 and the reception-side communication unit 2620 may transmit and receive charging state information and charging control commands. The charging state information may include the number of reception units 2000, a battery residual amount, the number of times of charging, a battery capacity, a battery ratio and a transmit power amount of the transfer unit 1000. In addition, the transfer-side communication unit 1520 may transmit a charging function control signal for controlling the charging function of the reception unit 2000, and the charging function control signal may be a control signal for controlling the reception unit 2000 to enable or disable the charging function.

The transfer-side communication unit 1520 may perform communication in an out-of-band format as a separate module. Embodiments are not limited thereto and communication may be performed in an in-band format using a feedback signal transferred from the reception unit to the transfer unit using a power signal transferred by the transfer unit and frequency shift of the power signal transferred by the transfer unit. For example, the reception unit may modulate the feedback signal and transfer charging start, charging end and battery state information to the transfer unit through the feedback signal. In addition, the transfer-side communication unit 1520 may be configured separately from the transfer-side controller 1510. In the reception unit 2000, the reception-side communication unit 2620 may be included in the controller 2610 of the reception unit or be provided separately from the controller 1610 of the reception unit.

In addition, the transfer unit 1000 of the wireless power transfer system according to the embodiment may further include a detector 1600.

The detector 1600 may detect at least one of the input signal of the transfer-side AC-to-DC converter 1100, the output signal of the transfer-side AC-to-DC converter 1100, the input signal of the transfer-side DC-to-AC converter 1200, the output signal of the transfer-side DC-to-AC converter 1200, the input signal of the transfer-side impedance matching unit 1300, the output signal of the transfer-side impedance matching unit 1300, the input signal of the transfer-side coil 1400 or the signal of the transfer-side coil 1400. The detected signal is fed back to the communication and control unit 1500. The communication and control unit 1500 may control the transfer-side AC-to-DC converter 1100, the transfer-side DC-to-AC converter 1200 and the transfer-side impedance matching unit 1300 based on the detected signal. In addition, the communication and control unit 1500 may perform foreign object detection (FOD) based on the result detected by the detector 1600. The detected signal may be at least one of a voltage and current. Meanwhile, the detector 1600 may be implemented in hardware different from that of the communication and control unit 1500 or the detector 1600 and the communication and control unit 1500 may be implemented together in hardware.

<Reception unit>

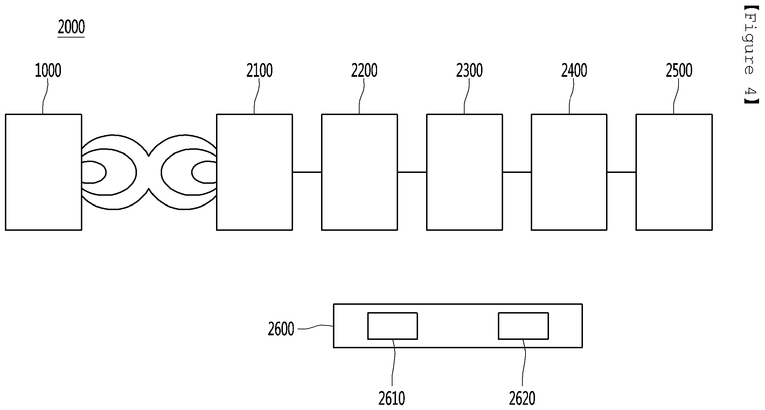

FIG. 4 is a block diagram showing a reception unit (or a reception unit) as one of subsystems configuring a wireless power transfer system.

Referring to FIG. 4, the wireless power transfer system according to the embodiment may include a transfer unit 1000 and a reception unit 2000 for wirelessly receiving power from the transfer unit 1000. The reception unit 2000 may include a reception-side coil unit 2100 and a reception-side impedance matching unit 2200, a reception-side AC-to-DC converter 2300, a DC-to-DC converter 2400, a load 2500 and a reception-side communication and control unit 2600.

The reception-side coil unit 2100 may receive power through the magnetic induction method or the magnetic resonance method. At least one of an induction coil or a resonant coil may be included according to the power reception method. The reception-side coil unit 2100 may be provided along with a near field communication (NFC) antenna. The reception-side coil unit 2100 may be equal to the transfer-side coil unit 1400 and the dimension of the reception antenna may be changed according to the electrical properties of the reception unit 200.

The reception-side impedance matching unit 2200 may perform impedance matching between the transfer unit 1000 and the reception unit 2000.

The reception-side AC-to-DC conversion unit 2300 rectifies the AC signal output from the reception-side coil unit 2100 and generates a DC signal.

The reception-side DC-to-DC converter 2400 may adjust the level of the DC signal output from the reception-side AC-to-DC converter 2300 according to the capacity of the load 2500.

The load 2500 may include a battery, a display, an audio output circuit, a main processor, and various sensors.

The reception-side communication and control unit 2600 may be activated by wakeup power from the transfer-side communication and control unit 1500 to perform communication with the transfer-side communication and control unit 1500 and to control operation of the subsystem of the reception unit 2000.

One or a plurality of reception units 2000 may be included to simultaneously and wirelessly receive energy from the transfer unit 1000. That is, in the magnetic resonance type wireless power transfer system, a plurality of target reception units 2000 may receive power from one transfer unit 1000. At this time, the transfer-side matching unit 1300 of the transfer unit 1000 may adaptively perform impedance matching between the plurality of reception units 2000. This is equally applicable to the case in which a plurality of reception-side coil units independent of each other in the magnetic induction method is included.

In addition, if a plurality of reception units 2000 is provided, power reception methods may be equal or different. In this case, the transfer unit 1000 may transfer power using the magnetic induction method, the magnetic resonance method or a combination thereof.

Meanwhile, in a relation between the level and frequency of the signal of the wireless power transfer system, in the case of magnetic induction type wireless power transfer, in the transfer unit 1000, the transfer-side AC-to-DC converter 1100 may receive and convert an AC signal of several tens or several hundred Hz (e.g., 60 Hz) of several tens or several hundred V (e.g., 110 V to 220 V) into a DC signal of several V to several tens or several hundred V (e.g., 10 to 20 V) and the transfer-side DC-to-AC converter 1200 receives a DC signal and output an AC signal of kHz band (e.g., 125 kHz). The reception-side AC-to-DC converter 2300 of the reception unit 2000 may receive and convert an AC signal of KHz band (e.g., 125 kHz) into a DC signal of several V to several tens or several hundred V (e.g., 10 V to 20 V), and the reception-side DC-to-DC converter 2400 may output a DC signal of 5 V, which is suitable for the load 2500, to the load 2500. In the case of magnetic resonance type wireless power transfer, in the transfer unit 1000, the transfer-side AC-to-DC converter 1100 may receive and convert an AC signal of several tens or several hundreds of Hz (e.g., 60 Hz) of several tens or several hundred V (e.g., 110 V to 220 V) into a DC signal of several V to several tens or several hundred V (e.g., 10 to 20 V), and the transfer-side DC-to-AC converter 1200 receives a DC signal and outputs an AC signal of MHz band (e.g., 6.78 MHz). The reception-side AC-to-DC converter 2300 of the reception unit 2000 may receive and convert an AC signal of MHz band (e.g., 6.78 MHz) into a DC signal of several V to several tens or several hundred V (e.g., 10 V to 20 V) and the reception-side DC-to-DC converter 2400 may output a DC signal of 5 V, which is suitable for the load 2500, to the load 2500.

<Operation State of Transfer unit>

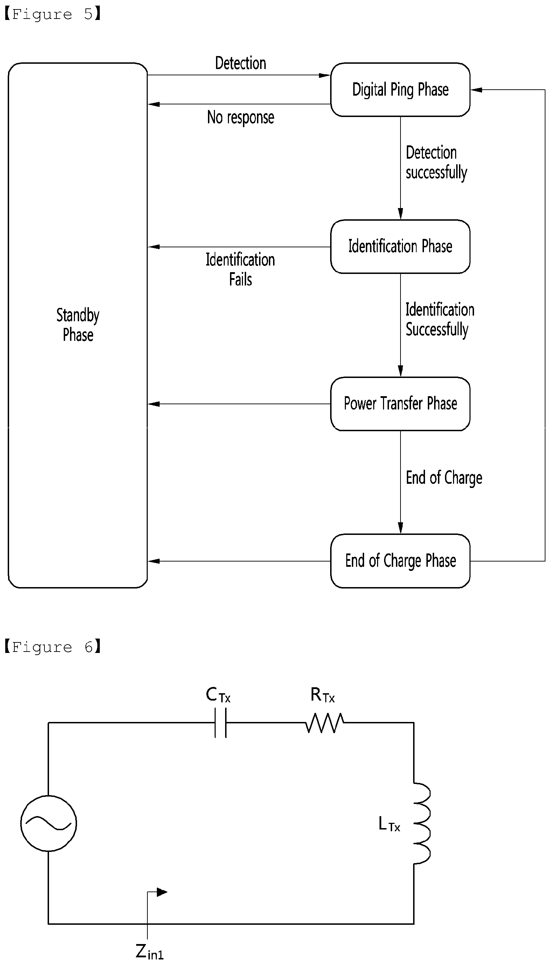

FIG. 5 is a flowchart illustrating operation of a wireless power transfer system, and, more particularly, an operation state of a transfer unit.

Referring to FIG. 5, the transfer unit according to the embodiment may have at least 1) a standby phase, 2) a digital ping phase, 3) an identification phase, 4) a power transfer phase and 5) an end-of-charge phase.

[Standby phase]

(1) When external power is applied to the transfer unit 1000 to start up the transfer unit 1000, the transfer unit 1000 may enter a standby phase. The transfer unit 1000 in the standby phase may detect presence/absence of an object (e.g., the reception unit 2000 or a metal foreign object (FO)) in the charging area. In addition, the transfer unit 1000 may detect whether the object is removed from the charging area.

(2) In the method of detecting presence of the object in the charging area at the transfer unit 1000, change in capacitance or inductance between the object and the transfer unit 1000 or shift of the resonant frequency may be monitored to detect the object, without being limited thereto.

(3) When the transfer unit 1000 detects the object, that is, the reception unit 2000, in the charging area, the phase may be switched to a digital ping phase as a next step.

(4) In addition, the transfer unit 1000 may detect a FO such as a metal FO in the charging area.

(5) Meanwhile, if the transfer unit 1000 does not obtain information capable of distinguishing between the reception unit 2000 and the FO in the standby phase, the phase is switched to the digital ping phase or the identification phase to determine whether the reception unit 2000 or the FO is present.

[Digital ping phase]

(1) In the digital ping phase, the transfer unit 1000 is connected to the chargeable reception unit 2000 to determine whether the reception unit 2000 is capable of being charged with wireless power received from the transfer unit 1000. In addition, the transfer unit 1000 may generate and output a digital ping having a predetermined frequency and timing in order to be connected to the chargeable reception unit 2000.

(2) When a sufficient power signal for digital ping is transferred to the reception unit 2000, the reception unit 2000 may modulate the power signal according to a communication protocol, thereby responding to the digital ping. When the transfer unit 1000 receives a valid signal from the reception unit 2000, the phase may be switched to the identification phase without removing the power signal. When an end-of-charge (EOC) request is received from the reception unit 2000, the phase of the transfer unit 1000 may be switched to the EOC phase.

(3) In addition, when the valid reception unit 2000 is not detected or when the response time of the object to the digital ping exceeds a predetermined time, the transfer unit 1000 may remove the power signal and the phase thereof return to the standby phase. Accordingly, if the FO is placed in the charging area, since the FO cannot send any response, the phase of the transfer unit 1000 may return to the standby phase.

[Identification phase]

(1) When the response of the reception unit 2000 to the digital ping of the transfer unit 1000 ends, the transfer unit 1000 may transmit transfer unit identification information to the reception unit 2000 to check compatibility between the transfer unit 1000 and the reception unit 2000. If compatibility is checked, the reception unit 2000 may transmit the identification information to the transfer unit 1000. In addition, the transfer unit 1000 may check the reception unit identification information of the reception unit 2000.

(2) The phase of the transfer unit 1000 may be switched to the power transfer phase when mutual identification ends and return to the standby phase when identification fails or when the identification time exceeds a predetermined identification time.

[Power Transfer phase]

(1) The communication and control unit 1500 of the transfer unit 1000 may control the transfer unit 1000 based on control data received from the reception unit 2000, thereby providing charging power to the reception unit 2000.
(2) Further, it is possible to determine whether the transfer unit 1000 operates in an appropriate operation range or whether a stability problem occurs due to FOD.
(3) In addition, when the transfer unit 1000 receives the EOC request signal from the reception unit 2000 or a temperature exceeds a predetermined temperature limit, the transfer unit 1000 may stop power transfer and the phase thereof may be switched to the EOC phase.
(4) In addition, when power cannot be appropriately transferred, the power signal may be removed and the phase of the transfer unit may return to the standby phase. In addition, after the reception unit 2000 is removed, when the reception unit 2000 enters the charging area, the above-described cycle may be performed again.
(5) In addition, the phase of the transfer unit may return to the identification phase according to the charging state of the load 2500 of the reception unit 2000, and charging power adjusted based on the state information of the load 2500 may be supplied to the reception unit 2000.

[End of Charge (EOC) phase]

(1) The phase of the transfer unit 1000 may be switched to the EOC phase upon receiving information indicating that charging ends from the reception unit 2000 or when the temperature of the reception unit 2000 increases to a predetermined temperature or more.
(2) When the transfer unit 1000 receives EOC information from the reception unit 2000, the transfer unit may stop power transfer and stand by for a predetermined time. After a predetermined time has elapsed, the transfer unit 1000 may enter the digital ping phase in order to be connected to the reception unit 2000 placed in the charging area.
(3) When the transfer unit 1000 receives information indicating that the temperature exceeds the predetermined temperature from the reception unit 2000, the transfer unit 1000 may stand by for a predetermined time. After a predetermined time has elapsed, the transfer unit 1000 may enter the digital ping phase in order to be connected to the reception unit 2000 placed in the charging area.
(4) In addition, the transfer unit 1000 may monitor whether the reception unit 2000 is removed from the charging area for a predetermined time and the phase thereof may return to the standby phase when the reception unit 2000 is removed from the charging area.

<FOD situation>

(1) If a metal foreign object such as a coin or a key is placed in the charging area, the FOD may be performed. Since the FOD increases the temperature of the transfer unit 1000 or the reception unit 2000 to a predetermined temperature or more and reduces energy efficiency, it is important to accurately detect presence/absence of the FO.
(2) FOD may be generated when the reception unit 2000 is not present in the charging area, when charging is being performed, when a foreign material is placed in the charging area upon charging, etc.
(3) As an FOD method, if the reception unit 2000 is not present and only the FO is present in the charging area, detection may be performed using a first FOD method of performing FOD by detecting an imaginary-number part of input impedance.
(4) In addition, as the FOD method, if the reception unit 2000 and the FO are present in the charging area, detection may be performed using a second FOD method of performing FOD by detecting an imaginary-number part of input impedance.

[First FOD situation: Method of performing FOD of the transfer unit if the reception unit is not placed in the charging area]

FIG. 6 is a circuit diagram showing an impedance matching unit and a transfer-side coil of a transfer unit as a serial RLC equivalent circuit.
Although the transfer-side coil 1400 is shown as being connected to the transfer-side impedance matching unit 1300 in series, the embodiment is not limited thereto and may be represented by an equivalent circuit of parallel connection or serial-parallel connection with the transfer-side impedance matching unit 1300.

(3-1) Referring to FIG. 6, the transfer-side impedance matching unit 1300 and the transfer-side coil 1400 of the transfer unit 1000 may be equivalently represented by a serial model of a transfer-side resistor $R_{Tx}$, the transfer-side inductor $L_{Tx}$ and the transfer-side capacitor $C_{Tx}$. In addition, the input impedance of the transfer-side coil 1400 and the transfer-side impedance matching unit 1300, that is, first input impedance $Z_{in1}$ viewed from the input port of the transfer-side impedance matching unit 1300 toward the transfer-side coil 1400 may become $Z_{in1} = (1/j\omega C_{Tx})$ + $R_{Tx} + j\omega L_{Tx}$. In addition, when the transfer-side inductor $L_{Tx}$ and the transfer-side capacitor $C_{Tx}$ resonate by the transfer-side impedance matching unit 1300, the first input impedance $Z_{in1}$ may become $2_{in1} = R_{Tx}$ to become pure resistance.

Meanwhile, in order to resonate the transfer-side inductor $L_{Tx}$ and the transfer-side capacitor $C_{Tx}$, the transfer-side impedance matching unit 1300 may adjust capacitance of the transfer-side capacitor $C_{Tx}$ under control of the communication and control unit 1500.

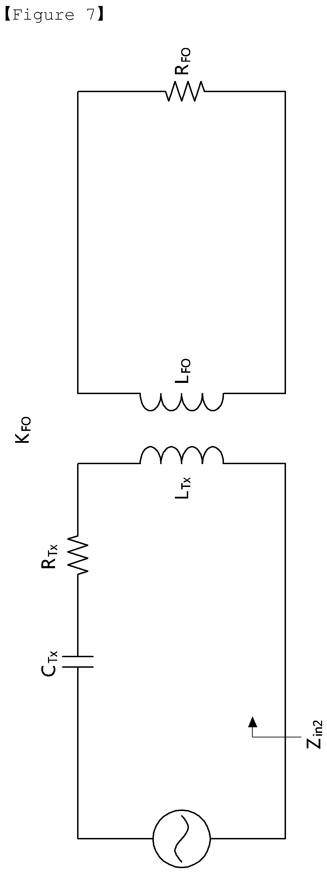

FIG. 7 is a circuit diagram showing an impedance matching unit and a transfer-side coil of a transfer unit as a serial RLC equivalent circuit and a foreign object (FO) equivalent circuit.

(3-2) Referring to FIG. 7, by placing the FO in the charging area of the transfer unit 1000, the transfer unit 1000 and the FO may be magnetically coupled to each other with a coupling coefficient $K_{FO}$.

The FO is a metal foreign object and may be equivalently modeled by a FO inductor $L_{FO}$ and a FO resistor $R_{FO}$.

The input impedance of the transfer-side coil 1400 and the transfer-side impedance matching unit 1300, that is, second input impedance $Z_{in2}$ from the input port of the transfer-side impedance matching unit 1300 toward the FO side may become

$$Z_{in2} \; = \; (1/j\omega C_{Tx}) \; + \; R_{Tx} \; + \; j\omega L_{Tx} \; + \; (\omega^2 \; k^2_{FO} \; L_{TX} \; L_{FO} \; / \; j\omega \; L_{FO} \; R_{FO})$$

= $Z_{in1} + \omega^2 k^2_{FO} L_{Tx} L_{FO} / (j\omega L_{FO} + R_{FO})$. When the transfer-side inductor $L_{Tx}$ and the transfer-side capacitor $C_{Tx}$ resonate by the transfer-side impedance matching unit 1300, the second input impedance $Z_{in2}$ may become $Z_{in2} = R_{Tx} + (\omega^2 k^2_{FO} L_{Tx} L_{FO} / j\omega L_{FO} R_{FO})$. When the denominator of a fraction is converted into a real number,

$Z_{in2} = R_{Tx} + \{(R_{FO} - j\omega L_{FO}) \omega^2 K^2_{FO} L_{Tx} L_{FO} / \omega^2 L^2_{FO} + R^2_{FO}\}$ may be obtained. In addition, generally, since a relationship of $\omega^2 L^2_{FO} >> R^2_{FO}$ is satisfied, the second input impedance $Z_{in2}$ may approximately become

$$Z_{in2} \; \fallingdotseq \; R_{Tx} \; + \; \{(R_{FO} \; - \; j\omega L_{FO})\omega^2 \; K^2_{FO} \; L_{Tx} \; L_{FO} \; / \; \omega^2 \; L^2_{FO}\}$$

$$= \; R_{Tx} \; + \; (R_{FO} \; K^2_{FO} \; L_{Tx} \; / \; L_{FO}) \; - \; j\omega K^2_{FO} \; L_{Tx}.$$

When the first input impedance $Z_{in1}$ and the second input impedance $Z_{in2}$ are compared, presence/absence of the imaginary-number part in the input impedance may be changed according to presence/absence of the FO. That is, it can be seen that, when the FO is not present, the first input impedance $Z_{in1}$ becomes pure resistance in a resonant state, but, when the FO is present, the second input impedance $Z_{in2}$ does not become pure resistance in the resonant state.

In addition, it can be seen that the real-number part of the second input impedance $Z_{in2}$

$$Real(Z_{in2}) \; \fallingdotseq \; R_{Tx} \; + \; (R_{FO} \; K^2_{FO} \; L_{Tx} \; / \; L_{FO})$$

is increased by $R_{FO} K^2_{FO} L_{Tx} / L_{FO}$ than the real-number part $Z_{in1} = R_{Tx}$ of the first input impedance $Z_{in1}$. That is, the value of the real-number part of the input impedance may be changed according to presence/absence of the FO.

(3-3) Unlike the first input impedance $Z_{in1}$, since an imaginary-number term is present in the second input impedance $Z_{in2}$, FOD may be performed by determining presence/absence of the imaginary-number term.

In addition, since the real-number part is increased due to presence of the FO, the FO may be detected by detecting change in a real-number part of the input impedance.

(3-4) As a method of determining presence/absence of the imaginary-number term, there are various methods. For example, ① 1) the frequency of the signal on the transfer-side coil 1400 of the transfer unit 1000 may be changed, 2) the transfer-side capacitor $C_{Tx}$ may be adjusted through the transfer-side impedance matching unit 1300 in order to maintain resonance according to frequency change, and 3) whether the level of the input impedance is changed may be checked, thereby performing FOD. That is, 3-1) when the FO is not present, the first input impedance $Z_{in1}$ is pure resistance regardless of the frequency and thus is constant, and 3-2) when the FO is present, FOD may be performed using the fact that the level of the second input impedance $Z_{in2}$ is changed according to the frequency.

② In addition, FOD may be performed by detecting a phenomenon that the level of the first input impedance $Z_{in1}$ determined as the transfer-side resistance $R_{Tx}$ value may be increased due to the FO resistance $R_{FO}$ and the FO inductor $L_{FO}$ of the FO to become the second input impedance $Z_{in2}$.

③ In addition, 1) the detector 1600 may detect at least one of 1. the input signal of the transfer-side AC-to-DC converter 1100, 2. the output signal of the transfer-side AC-to-DC converter 1100, 3. the input signal of the transfer-side DC-to-AC converter 1200, 4. the output signal of the transfer-side DC-to-AC converter 1200, 5. the input signal of the transfer-side impedance matching unit 1300, 6. the output signal of the transfer-side impedance matching unit 1300, 7. the input signal of the transfer-side coil 1400 or 8. the signal of the transfer-side coil 1400. 2) FOD may be performed based on change in detected signal.

[Second FOD situation: Method of performing FOD of the transfer unit after or while the reception unit is placed in the charging area]

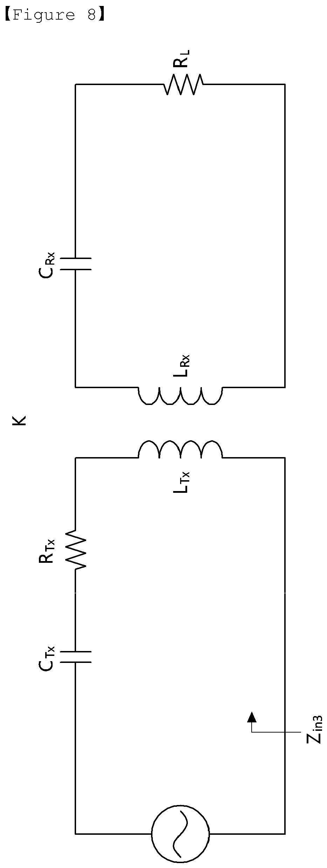

FIG. 8 is a circuit diagram showing an impedance matching unit and a transfer-side coil of a transfer unit and an impedance matching unit and a reception-side coil of a reception unit as a serial RLC equivalent circuit.

Although the reception-side coil 2100 is shown as being connected to the reception-side impedance matching unit 2200 in series, the embodiments are not limited thereto and may be represented by an equivalent circuit of parallel connection or serial-parallel connection with the reception-side impedance matching unit 2200.

(4-1) Referring to FIG. 8, the transfer unit 1000 and the reception unit 2000 may be magnetically coupled with a coupling coefficient K. In addition, the transfer-side impedance matching unit 1300 and the transfer-side coil 1400 of the transfer unit 1000 may be equivalently represented by a serial model of the transfer-side resistor $R_{Tx}$, the transfer-side inductor $L_{Tx}$ and the transfer-side capacitor $C_{Tx}$. In addition, the reception-side impedance matching unit 2200 and the reception-side coil 2100 of the reception unit 2000 may be equivalently represented by a serial model of the reception-side resistor $R_{Rx}$, the reception-side inductor $L_{Rx}$ and the reception-side capacitor $C_{Rx}$.

The input impedance of the transfer-side coil 1400 and the transfer-side impedance matching unit 1300, that is, third input impedance $Z_{in3}$ viewed from the input port of the transfer-side impedance matching unit 1300 toward the reception unit 2000 may become

$$Z_{in3} = 1/j\omega C_{Rx} + R_{Rx} + j\omega L_{Tx} + \omega^2 K^2 L_{Tx} L_{Rx} / \{ (1/j\omega C_{Rx}) + j\omega L_{Rx} + R_L \}.$$

In addition, when the transfer-side inductor $L_{Tx}$ and the transfer-side capacitor $C_{Tx}$ resonate by the transfer-side impedance matching unit 1300 and the reception-side inductor $L_{Rx}$ and the reception-side capacitor $C_{Rx}$ resonate by the reception-side impedance matching unit 2200, the third input impedance $Z_{in3}$ may become

$Z_{in3} = R_{Tx} + \omega^2 K^2 L_{Tx} L_{Rx} /R_L$ to become pure resistance.

Meanwhile, for resonance of the transfer-side inductor $L_{Tx}$ and the transfer-side capacitor $C_{Tx}$, the transfer-side impedance matching unit 1300 may adjust capacitance of the transfer-side capacitor $C_{Tx}$ under control of the communication and control unit 1500, and, for resonance of the reception-side inductor $L_{Rx}$ and the reception-side capacitor $C_{Rx}$, the reception-side impedance matching unit 2200 may adjust capacitance of the reception-side capacitor $C_{Rx}$ under control of the reception-side communication and control unit 2600.

In this case, When the FO is placed in the charging area, in the first FOD situation, as described above, an imaginary-number part may be added to the third input impedance $Z_{in3}$ by the FO to become fourth input impedance $Z_{in4}$. Accordingly, when the third input impedance $Z_{in3}$ and the fourth input impedance $Z_{in4}$ are compared, it can be seen that presence/absence of the imaginary-number part in the input impedance is changed according to presence/absence of the FO. That is, it can be ssen that, when the FO is not present, the third input impedance $Z_{in3}$ becomes pure resistance in a resonant state, and if the FO is present, the fourth input impedance $Z_{in4}$ does not become pure resistance in a resonant state.

In addition, as the FO is present in the charging area, due to increase in real-number part of the input impedance, the level of the real-number part of the fourth input impedance $Z_{in4}$ may be increased as compared to the real-number part of the third input impedance $Z_{in3}$.

(4-2) Unlike the third input impedance $Z_{in3}$, since an imaginary-number term is present in the fourth input impedance $Z_{in4}$, FOD may be performed by determining whether the imaginary-number term is present. In addition, due to presence of the FO, since the real-number part of the input impedance is increased, change in real-number part of the input impedance may be detected to detect the FO.

(4-3) As a method of determining whether an imaginary-number term is present, there are various methods. For example, ① FOD may be performed by detecting a phenomenon that the level of the third input impedance $Z_{in3}$ determined as the transfer-side resistor $R_{Tx}$ is changed due to the FO resistor $R_{FO}$ and the FO inductor $L_{FO}$ of the FO to become the fourth input impedance $Z_{in4}$.

② In addition, 1) the detector 1600 may detect at least one of 1. the input signal of the transfer-side AC-to-DC converter 1100, 2. the output signal of the transfer-side AC-to-DC converter 1100, 3. the input signal of the transfer-side DC-to-AC converter 1200, 4. the output signal of the transfer-side DC-to-AC converter 1200, 5. the input signal of the transfer-side impedance matching unit 1300, 6. the output signal of the transfer-side impedance matching unit 1300, 7. the input signal of the transfer-side coil 1400 and 8. the signal of the transfer-side coil 1400. 2) In addition, FOD may be performed based on change in detected signal.

[FO determination method based on detected signal]

In embodiments, the detector 1600 may detect the signal of the transfer unit 1000, and determine presence/absence of the imaginary-number part of the input impedance of the transfer unit 1000 based on the detected signal. The transfer-side communication and control unit 1500 may perform FOD based on the detected result of the detector 1600.

The detector 1600 may measure the output signal of the transfer-side DC-to-AC converter 1200 or the input signal of the transfer-side impedance matching unit 1300.

The signal detected by the detector 1600 may become a sine signal, the real-number part of the input impedance may be changed by the resistor $R_{FO}$ of the FO to change the amplitude of the detected signal, and the imaginary-number part of the input impedance may be formed by the FO capacitor $C_{FO}$ of the FO to change the width of the detected signal on the time axis. In particular, if the imaginary-number part is formed in the input impedance, the width of the detected signal on the time axis may be reduced. Accordingly, FOD may be performed by checking change in width of the detected signal on the time axis and, more particularly, decrease in width of the detected signal on the time axis.

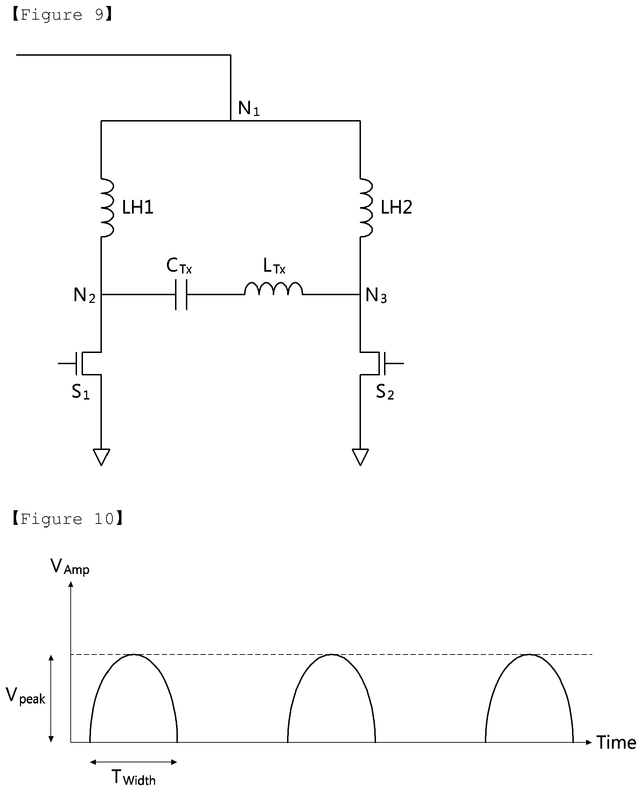

FIG. 9 is an equivalent circuit diagram of a transfer-side DC-to-AC converter, a transfer-side impedance matching unit and a transfer-side coil according to an embodiment. FIG. 10 is a diagram showing the output waveform of a transfer-side DC-to-AC converter of FIG. 9.

(2) Referring to FIG. 9, the transfer-side DC-to-AC converter 1200 according to the embodiment may become an amplifier for outputting only a positive half-period of the output AC signal. The transfer-side DC-to-AC converter 1200 may receive a DC signal $DC_1$ from the transfer-side AC-to-DC converter 1100 through a first node $N_1$ and output an AC signal through second and third nodes $N_2$ and $N_3$. In addition, current may flow in the transfer-side inductor $L_{Tx}$ by the AC signal of the second and third nodes $N_2$ and $N_3$ and power may be transferred to the reception-side coil 2100 of the reception unit 2000 through flux generated by flowing current.

The first transfer-side DC-to-AC converter 1200 may include first and second switches $S_1$ and $S_2$ and first and second high-side inductors LH1 and LH2. The first high-side inductor LH1 may be connected between the first and second nodes $N_1$ and $N_2$ and the second high-side inductor LH2 may be connected between the first and third nodes $N_1$ and $N_3$. In addition, the first switch $S_1$ may be connected between the second node $N_c$ and the reference ground, and the second switch $S_2$ may be connected between the third node $N_3$ and the reference ground.

A pulse width modulation signal may be supplied to the first and second switches $S_1$ and $S_2$ to alternately turn the first and second switches $S_1$ and $S_2$ on and the first and second switches $S_1$ and $S_2$ may operate with a predetermined frequency by the transfer-side communication and control unit 1500.

(3) Referring to FIG. 10, the transfer-side DC-to-AC converter 1200 of FIG. 9 may output a positive sine wave voltage through the terminals of the second and third nodes $N_2$ and $N_3$ which are the output terminals of the transfer-side DC-to-AC converter 1200 according to alternate operation of the first and second switches $S_1$ and $S_2$. That is, when the first switch $S_1$ is turned on and the second switch $S_2$ is turned off, current flows to the ground through the first high-side inductor LH1, the transfer-side capacitor $C_{Tx}$ and the transfer-side inductor $L_{Tx}$ and flows to the ground through the second high-side inductor LH2 to output the positive sine-wave voltage to the output terminal of the transfer-side DC-to-AC converter 1200. When the first switch $S_1$ is turned off and the second switch $S_2$ is turned on, current flows to the ground through the first high-side inductor LH1 and flows to the ground through the second high-side inductor LH2, the transfer-side inductor $L_{Tx}$ and the transfer-side capacitor $C_{Tx}$, thereby applying a voltage of 0V to the output terminal of the transfer-side DC-to-AC converter 1200 due to current offsetting of the transfer-side inductor $L_{Tx}$ and the second high-side inductor LH2.

(4) Meanwhile, if the FO is present in the charging area, the real-number part of the input impedance may be changed by the FO resistor $R_{FO}$ of the FO to change the amplitude $V_{peak}$ of the output signal $V_{Amp}$ of the output terminal of the transfer-side DC-to-AC converter 1200, and the imaginary-number part of the input impedance may be formed by the FO capacitor $C_{FO}$ of the FO to change the time width $T_{Width}$ of the output signal $V_{Amp}$ of the output terminal of the transfer-side DC-to-AC converter 1200.

Presence/absence of the FO may be determined by sensing change in the time width $T_{Width}$ of the output waveform of the output terminal of the transfer-side DC-to-AC converter 1200 according to the FO. In addition, presence/absence of the FO may be determined by detecting and comparing change in width $V_{peak}$ of the output waveform of the transfer-side DC-to-AC converter 1200 with a reference value. In addition, if the FO is placed in the charging area in a power transfer phase, presence/absence of the FO may be determined by detecting change in amplitude $V_{peak}$ of the output waveform of the output terminal of the transfer-side DC-to-AC converter 1200 due to rapid change in input impedance.

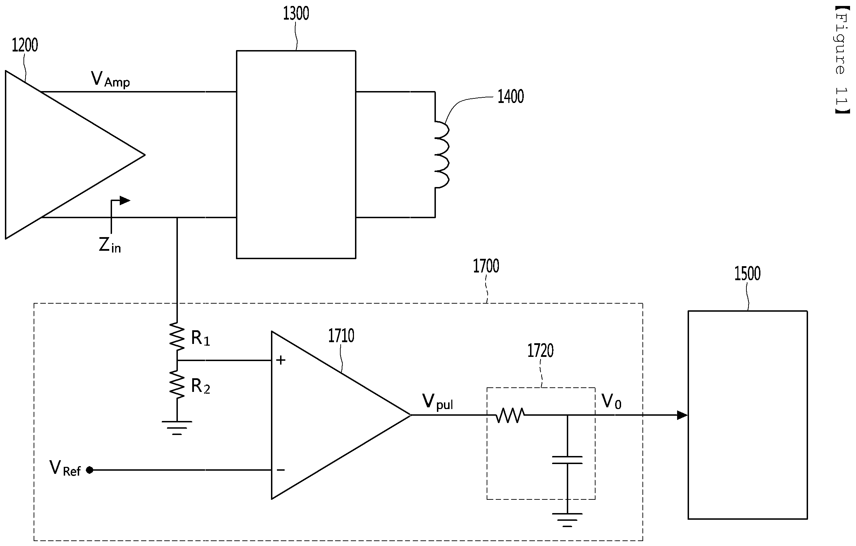

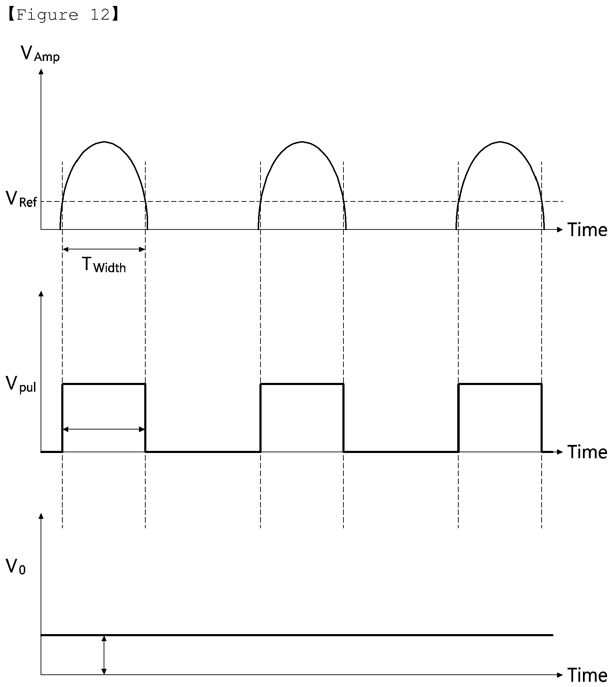

FIG. 11 is a circuit diagram showing a FO determination unit, and FIG. 12 is a graph showing the waveforms of input and output signals of the FO determination unit.

(5) Referring to FIGS. 11 and 12, as an embodiment of sensing change in time width $T_{width}$, the transfer unit 1000 according to the embodiment may include a FO determination unit 1700.

The FO determination unit 1700 may include a comparator 1710 and an RC filter 1720.

The comparator 1710 may receive the output voltage $V_{Amp}$ of the transfer-side DC-to-AC converter 1200 detected by the detector 1600 through resistor dividers R1 and R2 at a non-inverting terminal (+) thereof, receive a reference voltage $V_{Ref}$ at an inverting terminal (-) thereof, compare these voltages, and generate a pulse wave $V_{pul}$ having the same width as the time width $V_{Amp}$ of the transfer-side DC-to-AC converter 1200.

The RC filter may remove an AC signal and output a DC signal $V_o$ to the transfer-side communication and control unit 1500. The transfer-side communication and control unit 1500 may perform FOD by determining presence/absence of the FO based on the output voltage $V_o$ of the RC filter.

Meanwhile, the FO determination unit 1700 may be included in the detector 1600 or the transfer-side communication and control unit 1500. Accordingly, the detector 1600 may sense voltage or current information necessary to detect presence/absence of the imaginary-number part of the input impedance, perform the function of the FO determination unit 1700 based on the voltage or current information, and supply a final result to the transfer-side communication and control unit 1500. In addition, the transfer-side communication and control unit 1500 may perform the function of the FO determination unit 1700 based on the sensing information of the detector 1600.

Meanwhile, the transfer unit 10000 according to the embodiment may perform multi-charging if a plurality of reception units 2000 is placed in the charging area. Accordingly, when a plurality of objects is placed in the charging area, wireless power may be transmitted to at least one reception unit 2000 of the plurality of objects and presence/absence of the imaginary-number part of the input impedance of the transfer unit 1000 may be determined, thereby determining whether at least one of the plurality of objects is a metal foreign object.

<Phase transition according to FOD per phase>

(1) Standby phase

1) The transfer unit 1000 may determine whether there is an imaginary-number part of input impedance according to the above-described method when an object enters in a charging area in a standby phase, and recognize the object as a FO if there is an imaginary-number part. When the transfer unit 1000 detects the FO, a notification function may be performed such that a user audibly or visually recognizes the result of FOD.

2) In addition, when transfer unit 1000 detects the imaginary-number part of the input impedance, the standby phase may be maintained until the FO is removed from the charging area.

3) As another method of determining a FO, change in a real-number part of input impedance may be detected and it may be determined that the FO is present in the charging area if the change is equal to or greater than a reference value. Even when a valid reception unit 2000 is placed in the charging area, since the real-number part of the input impedance may be changed, the reference value may be acquired based on a result of experimentally comparing change in real-number part when the reception unit 2000 is placed with change in real-number part according to the FO.

4) In addition, the process of detecting change in real-number part of the input impedance and the imaginary-number part may be sequentially performed to detect FO, thereby more accurately performing FOD.

(2) Digital ping phase

1) The transfer unit 1000 may output a digital ping to the object to wait for a response of the object, when an object enters in a charging area in a digital ping phase. If the object is a FO, since the FO does not respond to the digital ping, the phase of the transfer unit 1000 may transition to the standby phase.

2) When an object entering the charging area is a reception unit 1000, the transfer unit 1000 may output a digital ping to the reception unit 1000 and wait for a response of the reception unit 1000. At this time, when a FO enters the charging area, a response signal to the digital ping may be received from the reception unit 1000 and, at the same time, detection of the imaginary-number part of the input impedance (or detection of change in real-number part of the input impedance or sequential performing of imaginary-number part detection and real-number part change detection) may be sensed. When the transfer unit 1000 detects a FO, a notification function may be performed such that a user audibly or visually recognizes a result of FOD. Such a notification function may be performed by the reception unit 2000 which receives the result of FOD from the transfer unit 1000 in addition to the transfer unit 1000. In addition, when the FO is not removed in spite of the notification function of the transfer unit 1000 for a predetermined time, the phase of the transfer unit 1000 may not transition to the identification phase as a next step and may transition to the standby phase.

(3) Identification phase

1) The transfer unit 1000 may output identification information of the transfer unit 1000 to the object and wait for reception of the identification information of the object, when there is an object entering the charging area in the identification phase. If the object is a FO, since the FO does not respond to the identification information, the phase of the transfer unit 1000 may transition to the standby phase.

2) When an object entering the charging area is the reception unit 1000, the transfer unit 1000 may output the identification information to the reception unit 1000 and wait for the response of the reception unit 1000,. At this time, when a FO enters the charging area, the identification information of the reception unit may be received from the reception unit 1000, and, at the same time, detection of the imaginary-number part of the input impedance (or detection of change in real-number part of the input impedance or sequential performing of imaginary-number part detection and real-number part change detection) may be sensed. When the transfer unit 1000 detects a FO, a notification function may be performed such that a user audibly or visually recognizes a result of FOD. Such a notification function may be performed by the reception unit 2000 which receives the result of FOD from the transfer unit 1000 in addition to the transfer unit 1000. In addition, when the FO is not removed in spite of the notification function of the transfer unit 1000 for a predetermined time, the phase of the transfer unit 1000 may not transition to the power transfer phase as a next step and may transition to the standby phase.

(4) Power transfer phase

1) If an object is present in the charging area in a process of transferring power from the transfer unit 1000 to the reception unit 2000, presence of the object may be checked by periodic detection of the imaginary-number part of the input impedance (or detection of change in real-number part of the input impedance or sequential performing of imaginary-number part detection and real-number part change detection). When the object is a FO, the phase of the transfer unit 1000 may transition to the standby phase. When the transfer unit 1000 detects the FO, a notification function may be performed such that a user audibly or visually recognizes a result of FOD. Such a notification function may be performed by the reception unit 2000 which receives the result of FOD from the transfer unit 1000 in addition to the transfer unit 1000.

2) In addition, the transfer unit 1000 may perform a temperature detection function. When the temperature of the charging area of the transfer unit 1000 increases to a predetermined temperature or more, a process of detecting the imaginary-number part of the input impedance may be performed. When the FO is detected, it may be determined that the temperature increases due to the FO, the determination may be notified to the user, and the phase of the transfer unit 1000 may transition to the standby phase.

Such a temperature detection function may be performed by the reception unit 2000. That is, when the temperature of the charging area increases to the predetermined temperature or more, the reception unit 2000 may transmit such information to the transfer unit 1000 such that the transfer unit 1000 performs FOD.

3) Meanwhile, the predetermined temperature may become a threshold temperature value or less for stable wireless transfer between the transfer unit 1000 and the reception unit 2000. If the predetermined temperature is less than the threshold temperature value, it is possible to check whether the temperature increases due to the FO in advance before a problem occurs in wireless power transfer stability.

In the wireless power transfer system according to the embodiment, the transfer unit 1000 can perform FOD through the process of detecting the imaginary-number part of the input impedance of the transfer unit 1000 in the transfer unit 1000, without a process of transmitting and receiving power transfer state information between the transfer and reception units, a process of determining power transfer efficiency between the transfer and reception units or a process of receiving information on the FO from the reception unit 2000 and performing FOD.

In addition, even when the reception unit 2000 is misaligned in the charging area, the coupling coefficient K between the transfer unit 1000 in the resonant phase and the reception unit 2000 in the resonant phase is only changed and the input impedance of the transfer unit 1000 may maintain pure resistance. Accordingly, even when the reception unit 2000 is misaligned in the charging area, it is possible to accurately perform FOD. Even when power efficiency is lowered due to misalignment of the reception unit in the charging area, it is possible to prevent erroneous determination that power efficiency is lowered due to a FO, thereby accurately performing FOD.

Although the invention has been described with reference to the exemplary embodiments, the present invention is not limited thereto and those skilled in the art will appreciate that various modifications and variations can be made in the present invention without departing from the spirit or scope of the invention. For example, those skilled in the art may modify the components of the embodiments. Differences related to such modifications and applications are interpreted as being within the scope of the present invention described in the appended claims.

**Claims**

1. A transfer unit having a wireless power transfer function, the transfer unit comprising:

   a coil;
   an impedance matching unit including a capacitor resonating with the coil; and
   a detector configured to detect presence/absence of an imaginary-number part of input impedance of the impedance matching unit and the coil.

2. The transfer unit according to claim 1, wherein presence/absence of the imaginary-number part of the input impedance is detected to detect whether an object is placed in a charging area of the transfer unit.

3. The transfer unit according to claim 2, wherein, when the imaginary-number part of the input impedance is detected, the object is determined as a metal foreign object.

4. The transfer unit according to claim 1, further comprising a direct current (DC)-to-alternating current (AC) converter configured to convert an input DC signal into an AC signal and to output the AC signal to the coil,
   wherein the detector senses the AC signal and detects presence/absence of the imaginary-number part of the input impedance.

5. The transfer unit according to claim 4, wherein the detector detects change in time width of the AC signal and detects presence/absence of the imaginary-number part of the input impedance.

6. The transfer unit according to claim 5, wherein, when a metal foreign object is placed in a charging area of the transfer unit, the time width is reduced.

7. A transfer unit having a wireless power transfer function, the transfer unit comprising:

   a power converter configured to convert power of an input signal and to output an alternating current (AC) signal;
   a resonant circuit unit configured to convert the AC signal into a magnetic field; and
   a detector configured to detect the AC signal,
   wherein change in time width of the AC signal is detected to determine presence/absence of an object in a charging area of the transfer unit.

8. The transfer unit according to claim 7, wherein, when the object is a metal foreign object, a time width of the AC signal is reduced.

9. The transfer unit according to claim 7, wherein the power converter includes an amplifier configured to output only a positive half-period of the AC signal.

10. The transfer unit according to claim 7, further comprising a controller configured to:

    generate a pulse signal having a width corresponding to a time width of a positive half-period of the AC signal, and generate a DC voltage, a level of which is changed according to a pulse width of the pulse signal, and compare the DC voltage with a predetermined value to determine presence/absence of the object.

11. The transfer unit according to claim 10, wherein the controller includes:

    a comparator configured to compare the AC signal with a reference voltage and to generate a pulse signal having a width corresponding to the time width of the positive half-period of the AC signal; and
    an RC filter configured to generate the DC voltage, the level of which is changed according to the pulse width of the pulse signal.

12. A transfer unit configured to wirelessly transfer power to at least one of a plurality of objects in a charging area, the transfer unit comprising:

    a power converter configured to convert power of an input signal and to output an alternating current (AC) signal;
    a transfer-side resonant circuit unit configured to convert the AC signal into a magnetic field; and
    a detector configured to detect the AC signal,
    wherein change in time width of the AC signal is detected to determine whether at least one of the plurality of objects is a metal foreign object.

13. The transfer unit according to claim 12, wherein, when at least one of the plurality of objects is a metal foreign object, a time width of the AC signal is reduced.

14. The transfer unit according to claim 12, wherein the power converter includes an amplifier configured to output only a positive half-period of the AC signal.

15. The transfer unit according to claim 12, further comprising a controller configured to:

    generate a pulse signal having a width corresponding to a time width of a positive half-period of the AC signal, and generate a DC voltage, a level of which is changed according to a pulse width of the pulse signal, and compare the DC voltage with a predetermined value to determine whether at least one of the plurality of objects is a metal foreign object.

16. The transfer unit according to claim 15, wherein the controller includes:

    a comparator configured to compare the AC signal with a reference voltage and to generate a pulse signal having a width corresponding to the time width of the positive half-period of the AC signal; and
    an RC filter configured to generate the DC voltage, the level of which is changed according to the pulse width of the pulse signal.

17. A transfer unit configured to wirelessly transfer power to at least one of a plurality of objects in a charging area, the transfer unit comprising:

a power converter configured to convert power of an input signal and to output an alternating current (AC) signal;

a transfer-side resonant circuit unit configured to convert the AC signal into a magnetic field; and

a detector configured to detect the AC signal,

wherein presence/absence of an imaginary-number part of input impedance of the resonant circuit unit is detected to determine whether at least one of the plurality of objects is a metal foreign object.

18. The transfer unit according to claim 17, wherein the detector senses the AC signal and detects presence/absence of the imaginary-number part of the input impedance.

19. The transfer unit according to claim 18, wherein the detector detects change in time width of the AC signal and detects the imaginary-number part of the input impedance.

20. The transfer unit according to claim 19, wherein, when at least one of the plurality of objects is a metal foreign object, the time width is reduced.

21. A method of operating a transfer unit, the method comprising:

a standby phase of determining presence/absence of an object in a charging area;

a digital ping phase of requesting a response to a digital ping from the object;

an identification phase of requesting identification information from the object; and

a power transfer phase of transmitting wireless power to the object,

wherein presence/absence of an imaginary-number part of input impedance of the transfer unit is detected to detect a metal foreign object placed in the charging area.

22. The method according to claim 21, wherein, when the imaginary-number part of the input impedance is detected, the transfer unit performs a notification function.

23. The method according to claim 21, wherein, when the imaginary-number part of the input impedance is detected in the standby phase, the transfer unit maintains the standby phase.

24. The method according to claim 21, wherein, when the imaginary-number part of the input impedance is detected in any one of the digital ping phase, the identification phase and the power transfer phase, the phase of the transfer unit transitions to the standby phase.

25. The method according to claim 24, wherein, when the imaginary-number part of the input impedance is detected in the power transfer phase, the transfer unit transmits metal foreign object detection information to a reception unit configured to receive power from the transfer unit.

26. The method according to claim 21, wherein, when a temperature of the charging area of the transfer unit is equal to or greater than a predetermined temperature, the transfer unit detects presence/absence of an imaginary-number part of input impedance.

27. The method according to claim 25, wherein, when information indicating that a temperature of the charging area is equal to or greater than a predetermined temperature is received from the reception unit configured to receive power from the transfer unit, the transfer unit detects presence/absence of an imaginary-number part of input impedance.

【Figure 1】

【Figure 2】

【Figure 3a】

1000

【Figure 3b】

【Figure 4】

【Figure 5】

【Figure 6】

【Figure 7】

【Figure 8】

【Figure 9】

【Figure 10】

【Figure 11】

【Figure 12】

## INTERNATIONAL SEARCH REPORT

| | International application No. |
|---|---|
| | **PCT/KR2016/004370** |

**A. CLASSIFICATION OF SUBJECT MATTER**

*H02J 17/00(2006.01)i, H02J 7/02(2006.01)i*

According to International Patent Classification (IPC) or to both national classification and IPC

**B. FIELDS SEARCHED**

Minimum documentation searched (classification system followed by classification symbols)
H02J 17/00; H04B 5/00; H01F 38/14; H02J 7/00; H03H 11/28; H03H 3/00; H02J 7/02

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: wireless power, transfer, impedance, matching, imaginary number part, existence and inexistence, detection, object, foreign substance, alternating current, time slot

**C. DOCUMENTS CONSIDERED TO BE RELEVANT**

| Category* | Citation of document, with indication, where appropriate, of the relevant passages | Relevant to claim No. |
|---|---|---|
| A | KR 10-2012-0015921 A (SAMSUNG ELECTRO-MECHANICS CO., LTD.) 22 February 2012 See paragraphs [26]-[165], claims 1-28, figures 1-12. | 1-27 |
| A | WO 2014-052161 A1 (QUALCOMM INCORPORATED) 03 April 2014 See paragraphs [77]-[110], figures 7-11. | 1-27 |
| A | JP 2014-183668 A (DAIHEN CORP. et al.) 29 September 2014 See abstract, paragraphs [27]-[30], figure 1. | 1-27 |
| A | US 2013-0221758 A1 (KAI, Toshihiro et al.) 29 August 2013 See paragraphs [43]-[66], figures 1-6. | 1-27 |
| A | US 2014-0240057 A1 (QUALCOMM INCORPORATED) 28 August 2014 See paragraphs [67]-[89], figures 6-12B. | 1-27 |

| ☐ Further documents are listed in the continuation of Box C. | ☒ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 AUGUST 2016 (10.08.2016) | **10 AUGUST 2016 (10.08.2016)** |

| Name and mailing address of the ISA/KR | Authorized officer |
|---|---|
| Korean Intellectual Property Office Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2016/004370**

| Patent document cited in search report | Publication date | Patent family member | Publication date |
|---|---|---|---|
| KR 10-2012-0015921 A | 22/02/2012 | CN 102378332 A | 14/03/2012 |
| | | CN 102378332 B | 25/03/2015 |
| | | KR 10-1184503 B1 | 20/09/2012 |
| | | US 2012-0038220 A1 | 16/02/2012 |
| WO 2014-052161 A1 | 03/04/2014 | CN 104685797 A | 03/06/2015 |
| | | EP 2901564 A1 | 05/08/2015 |
| | | JP 2015-537497 A | 24/12/2015 |
| | | KR 10-2015-0063081 A | 08/06/2015 |
| | | TW 201424186 A | 16/06/2014 |
| | | TW I515992 B | 01/01/2016 |
| | | US 2014-0091634 A1 | 03/04/2014 |
| | | US 9190876 B2 | 17/11/2015 |
| JP 2014-183668 A | 29/09/2014 | NONE | |
| US 2013-0221758 A1 | 29/08/2013 | CN 103210564 A | 17/07/2013 |
| | | CN 103210564 B | 09/03/2016 |
| | | EP 2639931 A1 | 18/09/2013 |
| | | EP 2639931 A4 | 23/03/2016 |
| | | JP 5641053 B2 | 17/12/2014 |
| | | KR 10-1478930 B1 | 31/12/2014 |
| | | KR 10-2013-0087536 A | 06/08/2013 |
| | | MX 2013005232 A | 28/06/2013 |
| | | RU 2013126687 A | 20/12/2014 |
| | | RU 2538762 C1 | 10/01/2015 |
| | | WO 2012-063570 A1 | 18/05/2012 |
| US 2014-0240057 A1 | 28/08/2014 | CN 105075135 A | 18/11/2015 |
| | | EP 2959606 A1 | 30/12/2015 |
| | | JP 2016-513448 A | 12/05/2016 |
| | | KR 10-2015-0121066 A | 28/10/2015 |
| | | TW 201448455 A | 16/12/2014 |
| | | US 2016-0043574 A1 | 11/02/2016 |
| | | US 9166562 B2 | 20/10/2015 |
| | | WO 2014-130334 A1 | 28/08/2014 |

Form PCT/ISA/210 (patent family annex) (January 2015)